# EUROPÄISCHE PATENTSCHRIFT

(11) **EP 4 179 719 B1**
(45) Veröffentlichungstag und Bekanntmachung des Hinweises auf die Patenterteilung: **18.09.2024**
(21) Anmeldenummer: 21749300.6
(22) Anmeldetag: 09.07.2021
(51) Int. Cl.: H04M 1/18, A45C 11/00, H01Q 1/24, H05K 5/00

(54) **FORMTEIL FÜR EIN MOBILES ENDGERÄT MIT SENDE UND/ODER EMPFANGSVORRICHTUNG AUS KOHLENSTOFFFASERVERSTÄRKTEM KUNSTSTOFF**
SHAPED PART FOR A MOBILE TERMINAL HAVING A TRANSMITTING AND/OR RECEIVING DEVICE, SAID SHAPED PART BEING COMPOSED OF CARBON-FIBER-REINFORCED PLASTIC
ÉLÉMENT MOULÉ POUR UN TERMINAL MOBILE COMPRENANT UN DISPOSITIF D'ÉMISSION ET/OU DE RÉCEPTION EN MATIÈRE PLASTIQUE RENFORCÉE PAR DES FIBRES DE CARBONE

(30) Priorität: 11.07.2020 DE 102020118348
(43) Veröffentlichungstag der Anmeldung: 17.05.2023
(73) Patentinhaber: Carbon Mobile GmbH, 10781 Berlin (DE)
(72) Erfinder: KHALIFEH, Firas, 10115 Berlin (DE)
(74) Vertreter: Castell, Klaus
(86) Internationale Anmeldenummer: PCT/IB2021/056173
(87) Internationale Veröffentlichungsnummer: WO 2022/013693

(56) Entgegenhaltungen:
- DE-A1- 102011 121 034
- DE-B3- 102011 114 119
- KR-A- 20140 004 336
- US-A1- 2015 024 811

## Beschreibung

Die Erfindung betrifft ein Formteil für ein mobiles Endgerät mit Sende und/oder Empfangsvorrichtung aus kohlenstofffaserverstärktem Kunststoff.

Zur Herstellung von mobilen Endgeräten mit Sende und/oder Empfangsvorrichtung, wie Mobiltelefone oder Tablet-Computer, ist es bekannt, das Gehäuse des mobilen Endgerätes aus kohlenstofffaserverstärktem Kunststoff herzustellen. Der kohlenstofffaserverstärkte Kunststoff weist dabei ähnliche Festigkeitswerte auf wie aktuelle Formteile aus Aluminium/Magnesiumguss. Besonders an dem kohlenstofffaserverstärkten Kunststoff ist, dass dieser Schläge aufnehmen kann, wie es beim Herunterfallen eines Gerätes aus Handhöhe gelegentlich der Fall ist, wobei die aufgenommene kinetische Energie in dem Kohlenstofffaserverbund dissipiert wird und nicht an weitere Bauteile weitergleitet wird. Noch ein Vorteil der Gehäuse aus kohlenstofffaserverstärktem Kunststoff ist das geringe Gewicht. Aktuelle Mobiltelefone, die als sog. "Smartphones" bekannt sind, weisen nicht selten ein Gewicht von 200 g und mehr auf, was zum Tragen in einer Anzugjackeninnentasche schon zu einer unerwünschten Verzerrung des Anzugs führt. Das einseitige Gewicht des Smartphones wird auch als störend empfunden. Bei in naher Zukunft zu erwartenden Klapp-Smartphones, also Smartphones mit faltbarem Display, erhöht sich das Gewicht erheblich, weil jedes Formteil etwa das Gewicht eines heute einzelnen Smartphones erreicht.

In der internationalen Patentanmeldung WO 2017/202751 A1 werden Polycarbonat-Zusammensetzungen enthaltend Füllstoffe, eine Carbonsäure und deren Glycerol- oder Diglycerolester offenbart, wobei die Füllstoffe Kohlenstofffasern sind. Ein solcher Verbundwerkstoff wird zur Verwendung zum Aufbau einer Dünnwandanwendung wie sog. Ultrabooks oder Smartphones vorgestellt. Weiterhin offenbaren, das Dokument US2015/0024811 A1 ein elektronisches Gerät das mit einem Abdeckelement aus faserverstärktem Kunststoff und das Dokument KR20140004336A ein mobiles Endgerät, bei dem eine Einlegeantenne mit einer hinteren Abdeckung des mobilen Endgerätes ausgebildet ist, um eine geringe Dicke der Antenne zu realisieren.

In der Regel werden Anwendungen von Kohlenstofffaserverbundwerkstoffen durch ihre mechanischen Eigenschaften und deren Gewicht charakterisiert. Ein eher modischer Nebeneffekt von Kohlenstofffaserverbundwerkstoffen ist die Sichtbarkeit des Kohlenstofffasergeleges oder des Kohlenstofffasergewebes.

Der Einsatz von Kohlenstofffaserverbundwerkstoffen hat einen überraschenden Nebeneffekt. Durch die hohe elektrische Leitfähigkeit der Kohlenstofffasern hat eine Gehäusewand für ein Mobiltelefon, ein Tablet-Computer oder ein Smartphone eine Wirkung wie ein faradayscher Käfig. Der Effekt ist um so stärker ausgeprägt, in je mehr Richtungen die Kohlenstofffaserfilamente regelmäßig gelegt sind. Es gibt unidirektionale

Kohlenstofffaserverbundwerkstoffe, die häufig mit UD-Verbund bezeichnet werden. Bei unidirektionalen Gelegen ist die Wirkung als faradayscher Käfig weniger stark ausgeprägt und die Abschirmung ist stark abhängig von der Gelegerichtung im Verhältnis zur Ausrichtung der Antenne innerhalb des mobilen Endgerätes. Weitere Einflussfaktoren sind die Frequenz der elektromagnetischen Strahlung und auch die Ausbreitung der elektromagnetischen Strahlung als Dipolantenne. Schon bei einem bidirektionalen Gewebe oder einem mehrlagigen Gelegen mit unterschiedlichen Richtungen der Filamente nimmt die Wirkung als faradayscher Käfig stark zu. Bei Geweben mit wenigen Filamenten, etwa 1.000 pro Strang, ist die abschirmende Wirkung so stark, dass ein Sende- und Empfangsvorgang nicht mehr möglich ist. Gegenüber einem anderen Kunststoffverbundwerkstoff hat Kohlenstofffaserverbundwerkstoff zunächst den Vorteil, dass die elektromagnetische Strahlung aus dem Mobiltelefon stark abgeschirmt wird. Die Abschirmleistung oder die Dämpfung der elektromagnetischen Strahlung ist vergleichbar mit der Dämpfung eines Gehäuses aus Aluminium/und/oder Magnesium.

Um eine Sende- und Empfangsantenne in einem mobilen Endgerät zu betreiben, ist es bei Aluminium und/oder Magnesiumgehäusen bekannt, an eine Kante des Gehäuses vom Rest des Gehäuses galvanisch zu trennen. Die galvanisch abgetrennte Kante wird als Antenne für die Sende- und Empfangssignale des mobilen Endgerätes genutzt. Solche galvanischen Trennungen einer Kante eines mobilen Endgerätes sind äußerlich an scheinbaren Designstreifen erkennbar. Tatsächlich aber sind die Streifen aus Kunststoff oder Glas, um die galvanische Trennung zur Verfügung zu stellen.

Ein vergleichbarer Aufbau eines Gehäuses aus kohlenstoffverstärktem Kunststoff ist nicht möglich.

Aufgabe der Erfindung ist es daher, ein Formteil für mobile Geräte aus kohlenstofffaserverstärktem Kunststoff zur Verfügung zu stellen, welches einen Betrieb einer Sende- und Empfangsantenne innerhalb des mobilen Gerätes ermöglicht. Die erfindungsgemäße Aufgabe wird dadurch gelöst, dass ein Antennenfenster als Auslassung ausgebildet ist, in das eine Einlegeantenne eingesetzt ist, welche über einen elektrischen Isolationskörper mit dem Formteil verbunden ist, wobei die Einlegeantenne aus dem Formteil herausragt. Weitere vorteilhafte Ausgestaltungen sind in den Unteransprüchen zu Anspruch 1 angegeben.

Nach dem Gedanken der Erfindung ist es vorgesehen, anders als es bei bekannten Formteilen für sendende, mobile Endgeräte bekannt ist, ein Antennenfenster in das Formteil einzubringen. Das Formteil besteht somit aus mindestens zwei verschiedenen Werkstoffen, wobei in vorteilhafter Weise der Werkstoff des Antennenfensters ebenso ein Faserverbundwerkstoff ist. Faserverstärkte Kunststoffe haben nämlich eine ausgeprägte Anisotropie in Bezug auf die Bruchfortpflanzung innerhalb ihres Gefüges. Um zu vermeiden, dass sich bei einem mechanischen Schlag auf das Gehäuse des mobilen Endgerätes, beispielsweise durch Herunterfallen, eine mechanische Stoßwelle an der Verbindung zwischen den unterschiedlichen Werkstoffen durch einen abrupten Wechsel der mechanischen Eigenschaften, wie örtlicher Elastizitätsmodul oder Schubmodul, so aufschaukelt, dass an der Verbindungslinie zwischen den unterschiedlichen Werkstoffen bevorzugt ein Riss entsteht, kann vorgesehen sein, dass das Antennenfenster aus glasfaserverstärktem Kunststoff besteht. Die Glasfasern können in identischer Richtung wie die Kohlenstofffasern verlegt oder mit dem gleichen Muster gewoben sein. Zwar sind die mechanischen Eigenschaften zwischen kohlenstofffaserverstärktem Kunststoff und glasfaserverstärktem Kunststoff unterschiedlich, aber die Anisotropie der lokalen mechanischen Eigenschaften der verschiedenen faserverstärkten Werkstoffe ist vergleichbar. Eine mechanische Stoßwelle breitet sich beim Übergang von dem einen Werkstoff zu dem zweiten Werkstoff gleichmäßiger aus. Ist das als Antennenfenster Auslassung ausgebildet, in das eine Einlegeantenne eingesetzt ist, so bildet die Einlegeantenne den zweiten Werkstoff des Antennenfensters aus.

Um die elektromagnetische Dämpfung des Werkstoffes im Bereich des kohlenstofffaserverstärkten Kunststoffes zu erhöhen, und gleichzeitig um die Isotropie der mechanischen Stoßwellenausbreitung zu vergleichmäßigen, kann vorgesehen sein, dass der kohlenstofffaserverstärkte Kunststoff als mehraxiales Carbongewebe ausgeführt ist. Dem gegenüber kann das Antennenfenster zur Anpassung der Stoßwellenausbreitung und aus glasfaserverstärktem Kunststoff bestehen.

Um die Stabilität im Bereich des Übergangs von kohlenstofffaserverstärktem Kunststoff und dem Antennenfenster zu erhöhen und eine Bruchneigung entlang der Verbindungslinie bei einem Schlag zu verringern, kann vorgesehen sein, dass die Verbindung zwischen dem kohlenstofffaserverstärkten Kunststoff und dem Antennenfenster als Hinterschneidung ausgebildet ist, wobei eine Negativform der Hinterschneidung in dem kohlenstofffaserverstärkten Kunststoff mit einer Positivform der Hinterschneidung am Antennenfenster korrespondiert, und wobei die Verbindung zwischen dem kohlenstofffaserverstärkten Kunststoff und dem Antennenfenster auf mindestens einer Seite mit einer Überspritzung überdeckt ist.

Durch die Hinterschneidung greifen die verschiedenen Werkstoffe fest ineinander. Die Überspritzung, die im Spritzgießverfahren auf das Formteil aufgebracht werden kann, sichert die formschlüssige Verbindung der Positivform und der Negativform der Hinterschneidung vor einem lateralen Herausbrechen.

Für eine weitere Stabilisierung der Verbindung zwischen dem kohlenstofffaserverstärkten Kunststoff und dem Antennenfenster kann vorgesehen sein, dass die Verbindung zwischen dem kohlenstofffaserverstärkten Kunststoff und dem Antennenfenster als Überlappung ausgebildet ist. Dazu kann der kohlenstofffaserverstärkte Kunststoff durch Fräsen auf etwa die Hälfte seiner Wandstärke reduziert sein. Das Antennenfenster kann durch Auflegen eines Prepregs und Pressen bei Hitze oder durch Auflegen eines thermoplastischen und glasfaserverstärkten Kunststoffes auf die abgefräste Fläche ausgebildet werden.

Als Alternative zu einem für elektromagnetische Strahlung durchlässigen Fensters durch die gesamte Wandung kann auch vorgesehen sein, dass in einer Wand des Formteils ein Antennenfenster eingearbeitet ist, dass nur bis etwa zur Hälfte der Wandstärke reicht. Um das Antennenfenster zu nutzen, kann in dem Fenster eine Antenne eingearbeitet sein, welche eine elektrische Verbindung durch die kohlenstofffaserverstärkte Wand hat, um die Antenne mit innerhalb des Formteils angeordneter Elektronik zu verbinden.

In besonderer Ausgestaltung der Erfindung kann vorgesehen sein, dass das Antennenfenster in die Oberfläche des Formteils aus kohlenstofffaserverstärktem Kunststoff eingebettet ist, wobei innerhalb des Antennenfensters eine Spulenantenne aus Kohlenstoffasern vorhanden ist. Kohlenstoffasern haben eine spezifische elektrische Leitfähigkeit, die mit metallischer elektrischer Leitfähigkeit vergleichbar ist und gegebenenfalls ist die Leitfähigkeit von Kohlenstofffasern noch höher. Kohlenstofffasern werden in der Regel mit thermoplastischem Kunststoff ummantelt, um sie beim Verpressen unter Hitze mit dem sie verbindenden Kunststoff zu verkleben. Diese Ummantelung führt zu einer guten elektrischen Isolierung der einzelnen Kohlenstofffasern. Werden nun in dem eingebetteten Antennenfenster die Kohlenstofffasern wie eine Spulenantenne gelegt, und werden die Enden der Kohlenstofffasern durch das Gewebe oder Gelege der Kohlenstofffasern zum Verstärken des Kunststoffes geführt, so kann die organische Kohlenstoffantenne wie eine metallische Antenne verwendet werden. Die Nutzung einer organischen Kohlenstofffaserantenne hat den weiteren Vorteil, dass die organische Hülle vollkommen transparent ist für Röntgenstrahlung. Mobiltelefone, Smartphones, Tablet-Computer können so bei einer Routinekontrolle am Flughafen oder in anderen Sicherheitsbereichen besser durchleuchtet werden. Zum Aufbau des Formteils kann vorgesehen sein, dass das Formteil ein mehraxiales Carbongewebe (Gewebe aus Kohlenstofffasern) aufweist, in welches eine Spule als Spulenantenne aus Kohlenstofffasern eingelegt ist, wobei die Enden der Kohlenstofffasern der Spulenantenne durch das mehraxiale Carbongewebe hindurchgeführt sind. Das mehrlagige Carbongewebe schirmt die innerhalb des Formteils vorhandene Elektronik gegenüber der Sendeleistung der Antenne ab.

In weiterer, alternativer Ausgestaltung des Formteils kann vorgesehen sein, dass im Bereich des Antennenfensters eine Einlegeantenne angeordnet ist, welche durch Überspritzen des kohlenstofffaserverstärkten Kunststoffes mit dem Formteil verbunden ist. Es ist nach dieser optionalen Ausgestaltung der Erfindung also vorgesehen, dass das Formteil mit einer Einlegeantenne ausgestattet ist, wobei die Einlegeantenne durch das Antennenfenster senden und empfangen kann.

Die Dichte der Kohlenstofffasern und die Dichte der Maschen des Gewebes haben einen Einfluss auf die abschirmende Wirkung gegenüber elektromagnetischer Strahlung im Bereich von 800 MHz bis 4 GHz. Als vorteilhafte Gewebemaschen haben sich solche Gewebe als vorteilhaft herausgestellt, die mit 1.000 Fasern pro Strang, mit 3.000 Fasern pro Strang und 12.000 Fasern pro Strang gewebt sind. Solche Kohlenstofffasergewebe werden im Handel als 1K (1.000 Fasern/Filamente), 3K (3.000 Fasern/Filamente) und 12K-Gewebe (12.000 Fasern/Filamente) angeboten. Das Formteil kann hergestellt werden durch Verpressen eines Prepregs in einer Form oder aus heißem Verformen eines thermoplastischen und kohlenstofffaserverstärkten Kunststoffes oder aus Fasern, die bereits mit einem thermoplastischen Kunststoff ummantelt sind.

In einer speziellen Ausgestaltung des erfindungsgemäßen Formteils kann vorgesehen sein, dass eine Seitenwand des Formteils eine metallische Hochleistungsantenne umfasst, wobei das Material des Antennenfensters die metallische Hochleistungsantenne galvanisch von dem kohlenstofffaserverstärkten Kunststoff trennt.

Die Erfindung wird anhand der folgenden Figuren näher erläutert. Es zeigt:
- Fig. 1: ein Formteil eines Smartphones aus dem STAND DER TECHNIK, hier als einteilige Form einer Schale,
- Fig. 2: ein erfindungsgemäßes Formteil aus Kohlenstofffaserverbundwerkstoff mit einem eingelassenen Antennenfenster,
- Fig. 3: eine Darstellung einer Verbindung zwischen Kohlenstofffaserverbundwerkstoff und einem eingesetzten Antennenfenster,
- Fig. 4: ein erfindungsgemäßes Formteil mit einem eingebettetem Antennenfenster und einer Kohlenstofffaserantenne,
- Fig. 5: einen Ausschnitt einer vergrößerten Ansicht auf die Schnittlinie A-A in Figur 4,
- Fig. 6: eine Ansicht auf die Innenseite einer weiteren alternativen Ausgestaltung eines erfindungsgemäßen Formteils mit einem ausgelassenen Antennenfenster,
- Fig. 7: eine Einlegeantenne,
- Fig. 8: die Einlegeantenne aus Figur 7 in einer perspektivischen Ansicht,
- Fig. 9: eine Ansicht auf die Innenseite das erfindungsgemäße Formteil aus Figur 6 mit einer durch Überspritzung eingeformten Einlegeantenne,
- Fig. 10: eine Ansicht auf die Außenseite das erfindungsgemäße Formteil aus Figur 6 mit einer durch Überspritzung eingeformten Einlegeantenne,
- Fig. 11: ein Detail der Seitenwand des erfindungsgemäßen Formteils mit einer Hinterschneidung,
- Fig. 12: das Detail aus Figur 10, in welcher die Hinterschneidung durch eine Überspritzung vermieden worden ist,
- Fig. 13: eine weitere Ausführungsform des erfindungsgemäßen Formteils aus Kohlenstofffaserverbundwerkstoff mit einem eingesetzten Antennenfenster und einer Hochleistungsantenne.

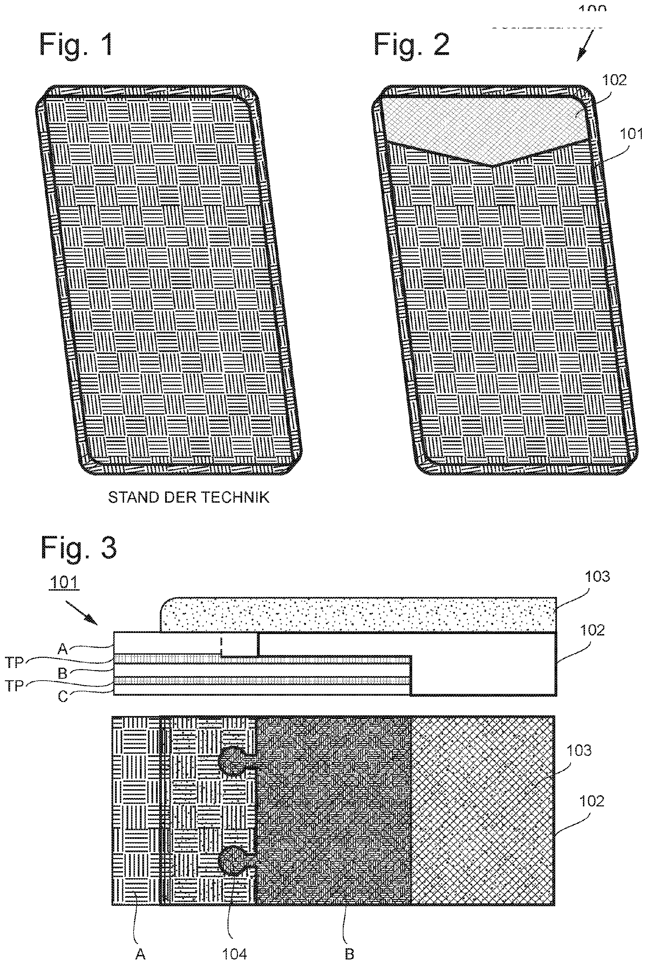

In **Figur 1** ist ein Formteil eines Gehäuses eines Smartphones aus dem Stand der Technik abgebildet. Das Formteil hat ein Monocoque-Aufbau, das bedeutet, es ist einschalig und weist nur ein einziges Wandmaterial auf. Das Formteil ist durch bekanntes Pressen eines Prepregs in einer Form hergestellt worden. Prepregs sind mit einem teilpolymerisierten Kunststoff getränkte Gewebematten. Der teilpolymerisierte Kunststoff ist dabei Epoxidharz oder ein Vinylester. Diese sind im kalten Zustand flexibel und können in einer Form vergelegt werden. Beim heißen Verpressen in einer Form polymerisiert der verbindende Kunststoff, so dass sich eine feste Form mit einer in der Regel dünnen Wand bildet.

In **Figur 2** ist ein erfindungsgemäßes Formteil 100 zur Verwendung für ein Smartphone oder ein Tablet-Computer gezeigt. Dieses Formteil 100 besteht aus zwei Werkstoffen. Der überwiegende Anteil des Formteils besteht aus kohlenstofffaserverstärktem Kunststoff 101, das in bekannter Weise durch Verpressen eines Prepregs mit Epoxidharz, mit Melaminharz oder mit einem Vinylesterharz hergestellt worden ist. Auch thermoplastische Werkstoffe kommen zum Einsatz, wobei die einzelnen Kohlenstofffasern mit einem thermoplastischen Werkstoff ummantelt sind. Erst beim Pressen des Gewebes in einer Form unter Hitze bildet sich das kohlenstofffaserverstärkte Formteil, wobei die Ummantelungen benachbarter Kohlenstofffasern miteinander verschmelzen. In dieser erfindungsgemäßen Ausgestaltung des Formteils ist vorgesehen, dass ein die gesamte Wandstärke umfassendes Antennenfenster 102 in das Formteil 100 eingebracht ist. Dabei kann das Antennenfenster 102 beispielsweise aus glasfaserverstärktem Epoxidharz bestehen. Das Antennenfenster 102 ist vorzugsweise an einem Ende eines Hochkantgehäuses untergebracht. An dieser Stelle befindet ich in bekannten Smartphones, Mobiltelefonen und/oder Tablet-Computern eine Antenne zum Senden und Empfangen von Radiostrahlung zur Kommunikation mit entfernten Sende- und Empfangsmasten. Um die lokalen mechanischen Eigenschaften des kohlenstofffaserverstärkten Kunststoffes 101 und des hier glasfaserverstärkten Epoxidharzes des Antennenfensters 102 aneinander anzupassen, kann vorgesehen sein, dass die Ausrichtung der Gewebefasern beider Kunststoffe gleichgerichtet ist.

In **Figur 3** ist eine Verbindung zwischen dem kohlenstofffaserverstärkten Kunststoff 101 und dem Antennenfenster 102 in Figur 2 entlang der Verbindungskante zwischen dem kohlenstofffaserverstärktem Kunststoff 101 und dem Antennenfenster 102 gezeigt. Der kohlenstofffaserverstärkte Kunststoff 101 besteht in dieser Ausführungsform aus drei Lagen A, B und C, die mit Kohlenstofffasergewebe einer unterschiedlichen bidirektionalen Maschendichte ausgestattet sind. Die unterschiedlichen Lagen A, B und C sind über einen thermoplastischen Werkstoff TP miteinander verbunden. Dabei besteht die innerste Lage A beispielsweise aus einem kohlenstofffaserverstärkten Kunststoff mit einem Kohlenstofffasergewebe mit 12.000 Kohlenstofffasern pro Webstrang, sogenanntes 12K-Gewebe. Die mittlere Schicht B besteht beispielsweise aus einem kohlenstofffaserverstärkten Kunststoff mit einem Kohlenstofffasergewebe mit 3.000 Kohlenstofffasern, sogenanntes 3K-Gewebe und die äußerste Schicht C besteht beispielsweise aus einem kohlenstofffaserverstärkten Kunststoff mit einem Kohlenstofffasergewebe mit 1.000 Kohlenstofffasern pro Webstrang, sogenanntes 1K-Gewebe. Zum Verbinden des kohlenstofffaserverstärkten Kunststoffes 101 mit dem Antennenfenster 102, das hier in diesem Beispiel aus einem glasfaserverstärkten Kunststoff besteht, wird das Formteil im Bereich der Kante des kohlenstofffaserverstärkten Kunststoffs 101 soweit abgetragen, dass die Schichtdicke nur noch etwa die Hälfte der gesamten Wandstärke des Formteils 100 entspricht, wobei jedoch ein Teil des die Lagen A und B verbindenden thermoplastischen Werkstoffes TP stehen bliebt. Dieser, die Lagen A und B verbindende thermoplastische Werkstoff TP dient als Verbindungsfläche zwischen dem kohlenstofffaserverstärkten Kunststoff und dem glasfaserverstärkten Kunststoff des Antennenfensters 102. Auf der sich ausbildende Zunge des kohlenstofffaserverstärkten Kunststoffs 101 mit etwa der halben Wandstärke liegt in diesem Beispiel ein glasfaserverstärkter Kunststoff auf. Dieser weist einzelne Hinterschneidungen 104 auf, die wie Zapfen aus dem glasfaserverstärkten Kunststoff des Antennenfensters 102 herausragen und sich beim Pressen eines Prepregs in korrespondierende und eingefräste Negativformen der Hinterschneidungen 104 ergießen. Beim Pressen des Prepregs des glasfaserverstärkten Kunststoffes für das Antennenfenster 102 verbindet sich das Epoxidharz des glasfaserverstärkten Kunststoffes das Antennenfensters 102 mit dem kohlenstofffaserverstärkten Kunststoff 101 des Formteils. Um die Hinterschneidungen davor zu bewahren aus den Negativformen herauszubrechen, ist eine Überspritzung 103 vorgesehen, die beim Pressen durch ein Spritzgusssystem auf die Verbindungskante der beiden unterschiedlichen Materialien aufgebracht wird.

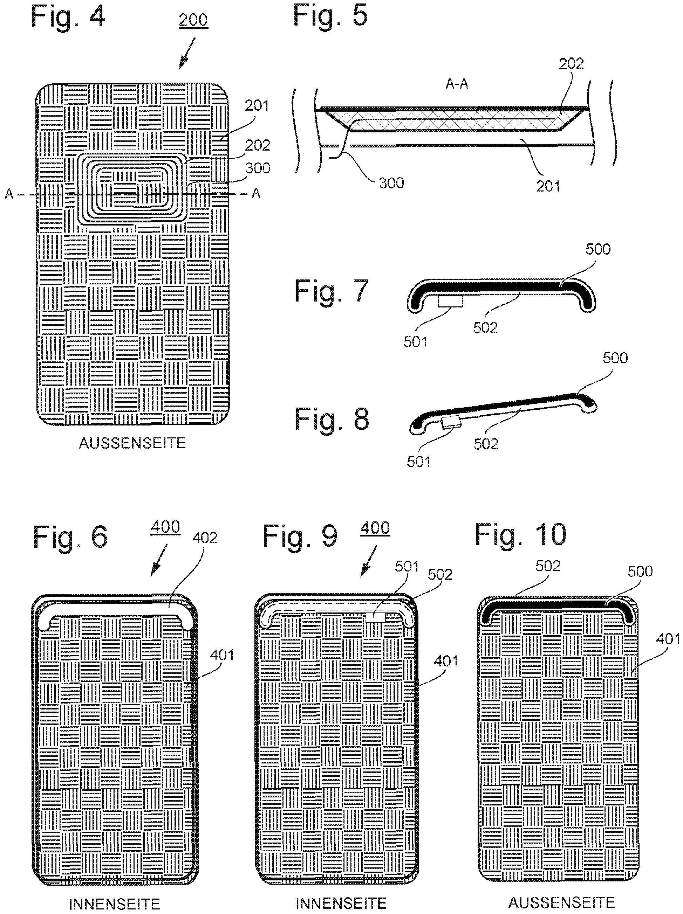

In **Figur 4** ist eine alternative Ausgestaltung des erfindungsgemäßen Formteils als Formteil 200 gezeigt. In diesem Formteil ist ein Antennenfenster 202 in die Oberfläche des kohlenstofffaserverstärkten Kunststoffes 101 eingebettet. Dabei ist die elektromagnetische Strahlung nicht abschirmende Schicht nur etwa halb so dick, wie die Wanddicke des Formteils 200. Das Antennenfenster 202 hat in diesem Fall eine eingebettete Antenne 300, die auch aus Kohlenstofffasern bestehen kann. Im Fall der Kohlenstofffaserantenne sind die Enden der einzelnen Fasern durch das Gewebe des kohlenstofffaserverstärkten Kunststoffes 101 hindurchgeführt, so dass die Enden mit einer entsprechenden Ansteuerelektronik verbunden werden können. Um die Lage der eingebetteten Antenne 300 zu verdeutlichen, ist in **Figur 5** eine Ansicht auf die Schnittlinie A-A in Figur 4 gezeigt. Die Antenne 300, die aus einzelnen Kohlenstofffasern bestehen kann, ist in das Antennenfenster 202 eingebettet, wobei das Antennenfenster 202 selbst in den kohlenstofffaserverstärkten Kunststoff 101 eingebettet ist. Die Einbettung kann durch einfaches Zusammenlegen eines Prepregs zum Pressen des kohlenstofffaserverstärkten Kunststoffes 101 und einer Antenne 300 erreicht werden, wobei beim sich beim Pressen der zusammengelegten Prepregs der Kunststoffanteil der Prepregs des kohlenstofffaserverstärkten Kunststoffes 101 und der Antenne 300 entsprechend formgebend um die einzelnen Kohlenstofffasern legt.

In **Figur 6** ist eine Ansicht auf die Innenseite einer noch weiteren Ausgestaltung des erfindungsgemäßen Formteils als Formteil 400 gezeigt. Das Formteil 400 weist ein Antennenfenster 402 auf, das selbst als Ausnehmung in das Formteil 400 ausgebildet ist. Diese Ausnehmung dient zur Aufnahme einer Einlegeantenne 500, die durch Überspritzen fest mit dem Formteil 400 verbunden ist. Dazu wird die Einlegeantenne 500 im Bereich des Antennenfensters 402 platziert und durch Überspritzen in einer Spritzform mit dem Antennenfenster 402 und dem kohlenstofffaserverstärkten Kunststoff 401 verbunden. Dabei ragt die Einlegeantenne 500 aus dem Formteil 400 heraus.

In **Figur 7** ist die Einlegeantenne 500 in einer Aufsicht dargestellt. Von oben erkennbar ist ein elektrischer Anschluss 501 und ein elektrischer Isolationskörper 502 zur Aufnahme der Einlegeantenne 500 und zur elektrischen Isolation gegenüber dem Formteil 400. Die gleiche Einlegeantenne 500 ist in Figur 8 perspektivisch dargestellt, wobei aus der perspektivischen Ansicht die auftragende Form des Isolationskörpers 502 hervorgeht. Die hier gezeigte Einlegeantenne 500 ist zusammen mit dem elektrischen Isolationskörper 502 gezeigt. Tatsächlich wird die Einlegeantenne 500 durch Überspritzen mit Kunststoff in der Form mit dem Formkörper 400 verbunden, wobei sich beim Überspritzen der elektrische Isolationskörper 502 ausbildet.

In **Figur 8** ist die Einlegeantenne auf Figur 7 in einer perspektivischen Ansicht gezeigt. Diese Einlegeantenne 500 wird mit der schmaleren Seite in die Ausnehmung des Antennenfenster 402 eingelegt und mit dem Formteil 400 durch Überspritzen verbunden. Dabei bildet sich der Isolationskörper 502 aus.

In **Figur 9** eine Ansicht auf die Innenseite das erfindungsgemäße Formteils 400 aus Figur 6 mit einer durch Überspritzung eingeformten Einlegeantenne 500 gezeigt. Der elektrische Isolationskörper 502 isoliert die Einlegeantenne 500 gegenüber dem Formteil 400. In dieser Ansicht ist die Einlegeantenne 500 gestrichelt gezeichnet, weil der elektrische Isolationskörper 502 die Einlegeantenne 500 verdeckt.

In **Figur 10** eine Ansicht auf die Außenseite das erfindungsgemäße Formteils 400 aus Figur 6 mit einer durch Überspritzung eingeformten Einlegeantenne 500 gezeigt. Der elektrische Isolationskörper 502 isoliert die Einlegeantenne 500 gegenüber dem Formteil 400.

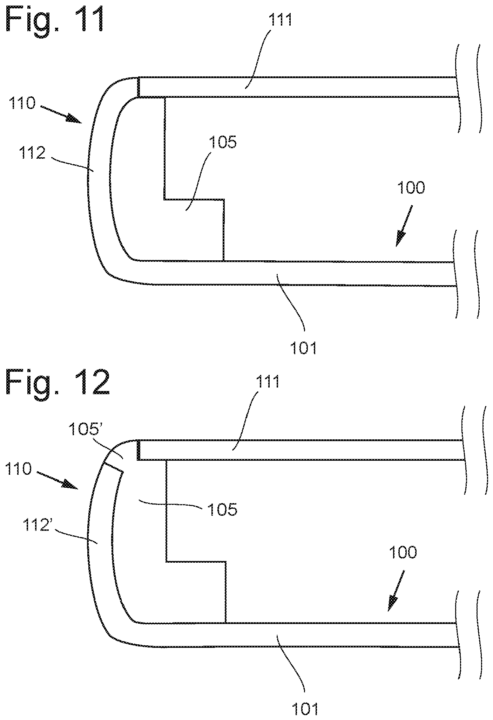

In **Figur 11** ist ein Schnitt durch das erfindungsgemäße Formteil 100 im Bereich einer Seitenwand 110 gezeigt. Der kohlenstofffaserverstärkte Kunststoff 101 wird in einer Form heiß gepresst. Um die Oberfläche des Formteils mit einem Display 111 bündig zu verbinden, ist es notwendig, dass das Display in einer Einfassung 112 liegt. Diese Einfassung 112 kann am besten durch eine umgelegte Wandung der Seitenwand 110 des Formteils gebildet werden, wie es in Figur 10 gezeigt ist.

Um zu vermeiden, dass sich eine Hinterschneidung in der Form bildet, die eine komplexe Form zum Entformen erfordert, dann eine Einfassung als 112' als Überspritzung 105 in die Kante des Formteils eingespritzt werden. Die Einfassung 112' lehnt sich an die innere Wand des Formteils an und bildet im Bereich der Wandoberkante der Seitenwand 110 eine Einfassung 105' für ein Display 111, wie es in **Figur 12** gezeigt ist. Die Einfassung als 112' ermöglicht, dass die Wandoberkante der Seitenwand 110 ohne Hinterschneidung in einer Form gepresst werde und leicht entformt werden kann.

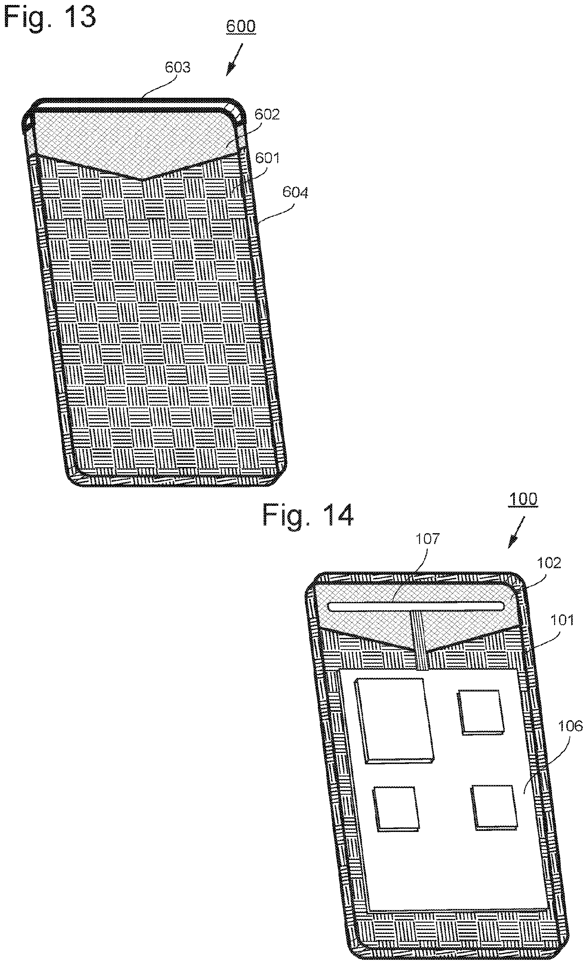

In **Figur 13** ist eine weitere Ausführungsform des erfindungsgemäßen Formteils 600 aus Kohlenstofffaserverbundwerkstoff mit einem eingesetzten Antennenfenster 602 und einer Hochleistungsantenne 603 dargestellt. Die Hochleistungsantenne 603 kann metallisch aufgebaut sein und Signale zur Kommunikation des mobilen Endgerätes zu einem entfernten Sendemast übernehmen. Um die Hochleistungsantenne 603 galvanisch von dem elektrisch leitfähigen, kohlenstofffaserverstärkten Kunststoff zu trennen, ist vorgesehen, dass das Material des Antennenfensters 602 die Hochleistungsantenne 603 in einer Seitenwand des Formteils aufnimmt und einfasst. Das Antennenfenster 602 dienst in diesem Beispiel für weniger leistungsstarke Sende- und Empfangsantennen, wie beispielsweise RFID-Antennen und Antennen für die Nahfeld- und Mittelfeldkommunikation.

In **Figur 14** das Formteil 100 aus Figur 2 dargestellt, wobei in dem Formteil 100 eine Platine 106 angeordnet ist, die mit einer Antenne 107 verbunden ist. Die Antenne 107 ist im Bereich des Antennenfensters 102 angeordnet, so dass die Antenne 107 ohne Abschirmung senden und empfangen kann.

### BEZUGSZEICHENLISTE

| | | | |
|---|---|---|---|
| 100 | Formteil | 400 | Formteil |
| 101 | kohlenstofffaserverstärkter Kunststoff | 401 | kohlenstofffaserverstärkter Kunststoff |
| 102 | Antennenfenster | 402 | Antennenfenster |
| 103 | Überspritzung | 404 | elektrischer Anschluss |
| 104 | Hinterschneidung | | |
| 105 | Überspritzung | 500 | Einlegeantenne |
| 105' | Einfassung | 501 | elektrischer Anschluss |
| 106 | Platine | 502 | elektrischer Isolationskörper |
| 107 | Antenne | | |
| 110 | Seitenwand | 600 | Formteil |
| 111 | Display | 601 | kohlenstofffaserverstärkter Kunststoff |
| 112 | Einfassung | | |
| 112' | Einfassung | 602 | Antennenfenster |
| | | 603 | Hochleistungsantenne |
| 200 | Formteil | 604 | Seitenwand |
| 201 | kohlenstofffaserverstärkter Kunststoff | A | Schicht |
| 202 | Antennenfenster | TP | thermoplastischer Werkstoff |
| 300 | Spulenantenne | B | Schicht |
| | | C | Schicht |

## Patentansprüche

1. Formteil (400) für ein mobiles Endgerät mit Sende und/oder Empfangsvorrichtung aus kohlenstofffaserverstärktem Kunststoff (101, 401) **dadurch gekennzeichnet, dass**
ein Antennenfenster (402) als Auslassung ausgebildet ist, in das eine Einlegeantenne (500) eingesetzt ist, welche über einen elektrischen Isolationskörper (502) mit dem Formteil (400) verbunden ist,
wobei die Einlegeantenne (500) aus dem Formteil 400 herausragt.

2. Formteil nach Anspruch 1,
**dadurch gekennzeichnet, dass**
der kohlenstofffaserverstärkte Kunststoff (101) als mehraxiales Carbongewebe ausgeführt ist.

3. Formteil nach Anspruch 1 oder 2,
**dadurch gekennzeichnet, dass**
das Antennenfenster (102) aus glasfaserverstärktem Kunststoff besteht.

4. Formteil nach einem der Ansprüche 1 bis 3,
**dadurch gekennzeichnet, dass**
die Verbindung zwischen dem kohlenstofffaserverstärkten Kunststoff (101) und dem Antennenfenster (102) als Hinterschneidung (104) ausgebildet ist,
wobei eine Negativform der Hinterschneidung (104) in dem kohlenstofffaserverstärkten Kunststoff (101) mit einer Positivform am Antennenfenster (102) korrespondiert, und wobei
die Verbindung zwischen dem kohlenstofffaserverstärkten Kunststoff (101) und dem Antennenfenster (102) auf mindestens einer Seite mit einer Überspritzung (103) überdeckt ist.

5. Formteil nach Anspruch 4,
**dadurch gekennzeichnet, dass**
die Verbindung zwischen dem kohlenstofffaserverstärkten Kunststoff (101) und dem Antennenfenster (102) als Überlappung ausgebildet ist.

6. Formteil nach Anspruch 1,
**dadurch gekennzeichnet, dass**
das Antennenfenster (202) in die Oberfläche des Formteils aus kohlenstofffaserverstärktem Kunststoff (101) eingebettet ist, wobei innerhalb des Antennenfensters (102) eine Spulenantenne (300) aus Kohlenstoffasern vorhanden ist.

7. Formteil nach Anspruch 6,
**dadurch gekennzeichnet, dass**
das Formteil (100) ein mehraxiales Carbongewebe aufweist, in welches eine Spule aus Spulenantenne (300) aus Kohlenstoffasern eingelegt ist, wobei die Enden der Kohlenstoffasern der Spulenantenne (300) aus Kohlenstoffasern durch das mehraxiale Carbongewebe hindurchgeführt sind.

8. Formteil nach einem der Ansprüche 1 bis 7,
**dadurch gekennzeichnet, dass**
im Bereich des Antennenfensters (402) eine Einlegeantenne (500) in einer Ausnehmung des Formteils angeordnet ist, welche durch Überspritzen des kohlenstofffaserverstärkten Kunststoffes (401) mit dem Formteil (400) verbunden ist.

9. Formteil nach einem der Ansprüche 1 bis 8,
**dadurch gekennzeichnet, dass**
der kohlenstofffaserverstärkte Kunststoff (101) aus mehr als einer Lage (A, B, C) besteht, bevorzugt zwischen 2 und 10 Lagen besteht, besonders bevorzugt aus drei Lagen besteht, in welchem die Kohlenstofffasern mit einer Leinwandbindung mit 1.000, 3.000 oder 12.000 Filamenten pro Bündel miteinander verwebt sind und benachbarte Lagen unterschiedliche Anzahl an Filamenten pro Bündel aufweisen.

10. Formteil nach einem der Ansprüche 1 bis 8,
**dadurch gekennzeichnet, dass**
kohlenstofffaserverstärkte Kunststoff (101) aus einem Prepreg oder aus mit thermoplastischem Kunststoff ummantelten Filamenten hergestellt ist.

11. Formteil nach einem der Ansprüche 1 bis 8,
**dadurch gekennzeichnet, dass**
eine Seitenwand (604) des Formteils (600) eine metallische Hochleistungsantenne (603) umfasst, wobei das Material des Antennenfensters (602) die metallische Hochleistungsantenne (603) galvanisch von dem kohlenstofffaserverstärkten Kunststoff (601) trennt.

## Claims

1. Shaped part (400) for a mobile device having a transmitting and/or receiving device, said shaped part being composed of carbon-fiber-reinforced plastic (101, 401),
***characterized in that***
an antenna window (402) is designed as an omission into which an insertion antenna (500) is inserted, said insertion antenna being connected to the shaped part (400) via an electrical insulating body (502),
wherein the insertion antenna (500) projects out of the shaped part (400).

2. Shaped part according to claim 1,
***characterized in that***
the carbon-fiber-reinforced plastic (101) is designed as a multiaxial carbon fabric.

3. Shaped part according to claim 1 or 2,
***characterized in that***
the antenna window (102) consists of glass-fiber-reinforced plastic.

4. Shaped part according to one of claims 1 to 3,
***characterized in that***
the connection between the carbon-fiber-reinforced plastic (101) and the antenna window (102) is designed as an undercut (104),
wherein a negative shape of the undercut (104) in the carbon-fiber-reinforced plastic (101) corresponds to a positive shape on the antenna window (102), and wherein
the connection between the carbon-fiber-reinforced plastic (101) and the antenna window (102) is covered on at least one side by an overmolding (103).

5. Shaped part according to claim 4,
***characterized in that***
the connection between the carbon-fiber-reinforced plastic (101) and the antenna window (102) is designed as an overlap.

6. Shaped part according to claim 1,
***characterized in that***
the antenna window (202) is embedded into the surface of the shaped part composed of carbon-fiber-reinforced plastic (101), wherein a coil antenna (300) composed of carbon fibers is present within the antenna window (102).

7. Shaped part according to claim 6,
***characterized in that***
the shaped part (100) has a multiaxial carbon fabric, into which a coil of a coil antenna (300), composed of carbon fibers, is inlaid,
wherein the ends of the carbon fibers of the coil antenna (300), composed of carbon fibers, are guided through the multiaxial carbon fiber.

8. Shaped part according to one of claims 1 to 7,
***characterized in that***
an insertion antenna (500) is arranged in a recess of the shaped part in the area of the antenna window (402) and said insertion antenna is connected to the shaped part (400) by the overmolding of the carbon-fiber-reinforced plastic (401).

9. Shaped part according to one of claims 1 to 8,
***characterized in that***
the carbon-fiber-reinforced plastic (101) consists of more than one layer (A, B, C), preferably consists of between 2 and 10 layers, particularly preferably consists of three layers, in which the carbon fibers are woven together using a linen weave with 1,000, 3,000, or 12,000 filaments per bundle and adjacent layers have different numbers of filaments per bundle.

10. Shaped part according to one of claims 1 to 8,
***characterized in that***
the carbon-fiber-reinforced plastic (101) is produced from a prepreg or from filaments coated with thermoplastic material.

11. Shaped part according to one of claims 1 to 8,
***characterized in that***
a side wall (604) of the shaped part (600) comprises a metallic high-performance antenna (603), wherein the material of the antenna window (602) electrically isolates the metallic high-performance antenna (603) from the carbon-fiber-reinforced plastic (601).

## Revendications

1. Élément moulé (400) pour terminal mobile comprenant un dispositif d'émission et/ou de réception en matière plastique renforcée par des fibres de carbone (101, 401),
***caractérisé en ce***
**qu'**une fenêtre d'antenne (402) est constituée sous forme d'une échancrure dans laquelle est insérée une antenne intégrée (500) qui est connectée par un corps isolant électrique (502) à l'élément moulé (400),
l'antenne intégrée (500) dépassant de l'élément moulé.

2. Élément moulé selon la revendication 1,
***caractérisé en ce que***
la matière plastique renforcée par des fibres de carbone (101) est réalisée sous forme d'un tissu de carbone multiaxial.

3. Élément moulé selon la revendication 1 ou 2,
***caractérisé en ce que***
la fenêtre d'antenne (102) est composée de matière plastique renforcée par des fibres de carbone.

4. Élément moulé selon une des revendications 1 à 3,
***caractérisé en ce que***
la liaison entre la matière plastique renforcée par des fibres de carbone (101) et la fenêtre d'antenne (102) est réalisée sous forme d'une contre-dépouille (104),
une forme négative de la contre-dépouille (104) correspondant dans la matière plastique renforcée par des fibres de carbone (101) à une forme positive de la fenêtre d'antenne (102), et
la liaison entre la matière plastique renforcée par des fibres de carbone (101) et la fenêtre d'antenne (102) est recouverte sur au moins une face par une sur-injection (103).

5. Élément moulé selon la revendication 4,
***caractérisé en ce que***
la liaison entre la matière plastique renforcée par des fibres de carbone (101) et la fenêtre d'antenne (102) est réalisée sous forme d'un chevauchement.

6. Élément moulé selon la revendication 1,
***caractérisé en ce que***
la fenêtre d'antenne (202) est encastrée dans la surface de l'élément moulé en matière plastique renforcée par des fibres de carbone (101), une antenne de bobine (300) en fibres de carbone étant présente à l'intérieur de la fenêtre d'antenne (102).

7. Élément moulé selon la revendication 6,
***caractérisé en ce que***
l'élément moulé (100) présente un tissu de carbone multiaxial dans lequel est insérée une bobine d'antenne à bobine (300) en fibres de carbone, les extrémités des fibres de carbone de l'antenne à bobine (300) étant passées à travers le tissu de carbone multiaxial.

8. Élément moulé selon une des revendications 1 à 7,
***caractérisé en ce que,***
au niveau de la fenêtre d'antenne (402), est disposée, dans un évidement de l'élément moulé, une antenne intégrée (500) qui est connectée, par sur-injection de la matière plastique renforcée par des fibres de carbone (401), à l'élément moulé (400).

9. Élément moulé selon une des revendications 1 à 8,
***caractérisé en ce que***
la matière plastique renforcée par des fibres de carbone (101) est composée de plus d'une couche (A, B, C), de préférence de 2 à 10 couches, très préférentiellement de trois couches, dans laquelle matière plastique les fibres de carbone sont tissées entre elles avec une armure toile comportant 1 000, 3 000 ou 12 000 filaments par faisceau et que les couches voisines présentent un nombre différent de filaments par faisceau.

10. Élément moulé selon une des revendications 1 à 8,
***caractérisé en ce que***
la matière plastique renforcée par des fibres de carbone (101) est fabriquée à partir d'un préimprégné ou de filaments enrobés de matière plastique thermoplastique.

11. Élément moulé selon une des revendications 1 à 8,
***caractérisé en ce***
**qu'**une paroi latérale (604) de l'élément moulé (600) comprend une antenne métallique à haute puissance (603), le matériau de la fenêtre d'antenne (602) séparant l'antenne métallique à haute puissance (603) de manière galvanique de la matière plastique renforcée par des fibres de carbone (601).
